# EUROPEAN PATENT APPLICATION

(11) **EP 4 811 424 A1**
(43) Date of publication of application: **23.09.2026**
(21) Application number: 25165377.0
(22) Date of filing: 21.03.2025
(51) Int. Cl.: H01L 21/677, H01L 21/687

(54) **AN APPARATUS FOR USE IN SEMICONDUCTOR MANUFACTURING WITH A CRANE TO DISPLACE PART OF THE APPARATUS AND A METHOD FOR DISPLACING PART OF AN APPARATUS**

(71) Applicant: Polyteknik A/S, 9750 Øster Vrå (DK)
(72) Inventor: LARSEN, Jens William, 9330 Dronninglund (DK); CHRISTIANSEN, Rasmus Viking Lømand Ravgård, 9750 Øster Vrå (DK)
(74) Representative: Patrade A/S

(57) **Abstract**

An apparatus (100) for use in semiconductor manufacturing, the apparatus (100) defines a first zone (142), and a second zone (144) being outside the first zone (142); and the apparatus (100) comprising:
- a crane (130) comprising
- a crane arm (131) comprising a series of arm segments (132) interconnected through flexible joints (133), where each flexible joint (133) defines a rotary axis and the arm segments (132) being rotatable around the rotary axes, and
- engagement means (135) arranged on at least one of the arm segments (132), where the engagement means (135) are configured for engaging part of the apparatus (100);

at least one arm segment (132) being displaceable between part of the first zone (142) to part of the second zone (144).

## Description

### Field of the Invention

The present invention relates to an apparatus for use in semiconductor manufacturing with a crane to displace part of the apparatus and a method for displacing part of an apparatus.

### Background of the Invention

Apparatuses for use in semiconductor manufacturing such as linear cluster tools or circular cluster tools are well-known in the art. The cluster tool may include a transfer chamber connected to a number of process chambers, wherein the process chamber defines the treatment of wafers being treated in the cluster tool. Wafers are introduced into the cluster tool via transfer chambers interconnecting the cluster tool with a loader/unloader unit such as an Equipment Front End Module (EFEM). The loader/unloader unit may be configured for receiving wafer cassettes.

In many cases, the ideal positioning of the different apparatuses, i.e. cluster tools, are such that there is sufficient room around each cluster tool to enable servicing by removing or replacing or interacting with at least part of the cluster tool, such as at least part of the transfer chamber or at least part of the process chamber. However, these facilities are expensive hence the wafer production per square meter is an important parameter for reducing cost, thus the wafer production per square meter will often be maximized. Thereby, free space around the cluster tools is reduced as much as possible.

Thus, if it is possible to design a cluster tool enabling that the area of non-production or free space can be reduced further then that would be desired. This is especially a problem for process chamber as described in PCT/EP2024/072879, wherein the entire wafer is linear displaced back and forth through a deposition zone, and the change of direction is performed in zones without deposition, as this will make the process chamber longer than process chambers wherein the wafer is stationary. Figure 5 of PCT/EP2024/072879 describes why the process chamber needs additional length in order to enable a change in velocity vector in a zone without deposition.

### Object of the Invention

One objective of the present disclosure is to achieve an apparatus for use in semiconductor manufacturing with a crane to displace part of the apparatus, thereby enabling easier change of parts and better use of space of a manufacturing floor of a cleanroom.

### Description of the Invention

One objective of the invention is achieved by an apparatus for use in semiconductor manufacturing. The apparatus defines a first zone, and a second zone being outside the first zone; and the apparatus comprising:
- a crane comprising:
   - a crane arm comprising a series of arm segments interconnected through flexible joints, where each flexible joint defines a rotary axis and the arm segments being rotatable around the rotary axes;
   - engagement means arranged on at least one of the arm segments, where the engagement means are configured for engaging part of the apparatus.

At least one arm segment being displaceable between part of the first zone to part of the second zone.

The apparatus for use in semiconductor manufacturing defines a first zone by simply being in a space. Thus, the first zone can be seen as the projection of the apparatus onto a floor on which the apparatus is positioned. The first zone may include space above the apparatus as said space is not accessible or useable by other apparatuses for use in semiconductor manufacturing. The apparatus may be a cluster tool, and the apparatuses may be cluster tools.

Depending on the layout at the manufacturing floor, at least some parts of the apparatus are not accessible for service and/or the parts are accessible with great difficulty resulting in increased maintenance time. In most cases, space around the apparatus will be limited due to the need for efficiently utilize manufacturing floor. More specifically, the space is limited due to deploying extensive manufacturing equipment within the production area. Thus, space efficiency is a preferred strategy in the semiconductor industry to fully utilize manufacturing space.

One purpose of the apparatus for use in the semiconductor industry is to enable effortless and space-efficient performance of tasks around the apparatus in within the first zone and second zone. The apparatus may work as a cluster tool to process semiconductor components, where the crane can perform different tasks within the first zone and second zone, such as supporting maintenance/service. The crane will be able to support in holding parts from the apparatus, for example hold parts clear of the apparatus for better access. In another example, the crane will be able to displace the part to another position, where accessibility to the part is further increased. This could for example be from the first zone to the second zone or vice versa. The crane can thus give better accessibility to the apparatus and thereby decrease maintenance/service time and decrease the risk of mistakes.

Another advantage of the crane, as it is able to hold parts of the apparatus, is that it reduces the risk of injuries, as the crane holds most of the weight of the part. Thereby, increasing safety, when working on the apparatus.

Manufacturing floors within a factory in the semiconductor industry is very complex, due to the conditions that needs to be maintained to produce high quality products. As an example, most of the manufacturing in the semiconductor industry must take place within a cleanroom. Since these cleanrooms are complicated to maintain, the manufacturing floor within the cleanroom must be space-efficiently utilized.

Therefore, another purpose of the apparatus for use in the semiconductor industry is to better utilize the manufacturing floor. The additional accessibility provided by the crane also decreases the needed accessible space around the apparatus. When less accessible space around the apparatus is needed, the manufacturing floor can be more efficiently utilized.

The rotary axes of the flexible joint are preferably all substantially parallel to gravitation vector thereby making the crane arm stable at any position since the crane arm can be displaced without changing the potential energy of the crane. If the crane is holding a part of the apparatus and the height of said part is changed by lowering or raising said part, then potential energy of the crane and part is of course changed however any displacement of said part in a horizontal plane will not change the potential energy thereby making the crane stable.

The flexible joints may be equipped with friction elements to create a small amount of friction as the rotary axes will be substantially parallel to the gravitation vector but not perfectly aligned.

In one further embodiment of the apparatus, the second zone may be defined by the reach of the crane arm. The reach of the crane arm may be determined by the number of arm segments and the extend of the arm segments in the horizontal plane. This ensures that the arm segments displaceability can be configured for a wider range of accessible areas around the apparatus, depending on the need.

The arm segments may extend from an attachment arm segment connected to a crane pillar and a distal arm segment, wherein the arm segments include one or more intermediate arm segment between the attachment arm segment and the distal arm segment. The arm segments may decrease in size from the attachment arm segment to the distal arm segment or from an intermediate arm segment to the distal arm segment or to another intermediate arm segment being closer to the distal arm segment. Thereby, the lever principle effect is minimized by reducing weight distal to the attachment arm segment.

Furthermore, the modular construction of the arm segments of the crane arm, facilitates flexibility of the crane and the crane arm will thus be able to displace to many different positions within its reach. There may be other units within the room which can block the crane arm thereby preventing the position even though the position is within the reach of the crane arm.

The engagement means may be arranged on an end arm segment of the arm segments, thereby the largest displacement range can be obtained for the engagement means. The engagement means may be positioned on one or more arm segments or any arm segment of the arm segments such that the crane arm can be adjusted to a specific task. The engagement means may be arranged on several arm segments.

The engagement means may be displaced between arm segments, thereby adjusting the position of the engagement means.

The crane arm may be configured for displacing at least one part of said transfer chamber between the first zone and the second zone thereby enabling maintenance and installation of components of the transfer chamber.

In an embodiment, the apparatus may be a linear cluster tool, wherein the apparatus may be a linear cluster tool, wherein a transfer chamber comprises one chamber side with the openings or two chamber sides with the openings for connection with process chambers. The two chamber sides may for a linear cluster tool be substantially parallel. The process chambers will when attached to the openings be part of the apparatus and thus the process chambers will also define the first zone.

The apparatus and process chambers may work with handling and treatment of wafers, such as silicon wafers used in the semiconductor industry.

A linear cluster tool may be an automated system generally used to process wafers, furthermore, the linear cluster tool may comprise a transfer chamber and typically multiple process chambers connected to the openings of the transfer chamber. The linear cluster tool, ensures consistent and reliable handling of wafers within the system, reducing risks of contamination.

During use of the apparatus, the transfer chamber regularly needs be maintained and/or have service performed. It might be difficult to access the transfer chamber if there is a lot of process chambers connected. With the apparatus comprising a crane, the crane is able to support in, for example holding parts, this significantly reduces the workspace needed around the apparatus. This increases the space-efficiency of the apparatus. Furthermore, the crane may also increase the speed at which this maintenance and/or service is performed.

In a further embodiment of the apparatus, the transfer chamber will be within the first zone, and thereby the crane is able to engage with the transfer chamber using the engagement means. Furthermore, as the crane arm is able to be displaced between the first zone and the second zone, the crane is able to engage with parts in the first zone and displace said parts to the second zone or displace parts from the second zone to the first zone. The crane arm may also displace engaged parts between one place to another within a single zone.

Additionally, the crane is suitable for displacing parts of the apparatus, such as a robot unit, between the first zone and the second zone.

In one aspect of the apparatus, the transfer chamber comprises a robotic handling unit, that may be able to handle wafers during the transfer from one destination to another.

The transfer chamber may be equipped with a load lock, that ensures controlled transfer from outside the transfer chamber and into the transfer chamber. The outside may be an EFEM or wafer cassette or ambient atmosphere within a cleanroom.

In an embodiment, the apparatus may be a circular-like cluster tool comprising a transfer chamber having two or more chamber sides with openings for connection with process chambers. The circular-like cluster tool may comprise five or more sides defining an approximation of a circle hence the wording circular-like.

In many embodiments, each chamber side of the circular-like cluster tool will have a single opening for connection with a process chamber as the distance from the openings to a center section of the transfer chamber can be substantially the same which makes transfer of wafers between process chambers easier.

By having the apparatus be a circular-like cluster tool and not linear cluster tool, makes it easier for the crane to be displaced above all of the apparatus.

The circular cluster tool or linear cluster tool may be a semiconductor cluster tool.

In an embodiment, the apparatus may comprise at least two process chambers; and the at least two process chambers form part of the first zone; wherein the crane arm is configured for reaching the at least two process chambers within the first zone.

Space efficiency is, as mentioned above, a preferred strategy in the semiconductor industry to fully utilize manufacturing space. However, a skilled person would know that maintaining/servicing process chambers often demand a large accessible area around the process chamber, which limits efficient utilization of manufacturing floor. An advantage of the apparatus of this invention, is that the crane that can support in maintaining and/or service of the process chambers, by holding the process chamber or parts of the process chamber. By holding the process chamber or part of the process chamber will make it more convenient for maintenance and service.

In one embodiment, the crane is able to hold the process chamber, or part of the process chamber above the original position of the process chamber or part of the process chamber. In another embodiment, the crane is capable of holding and displacing the process chamber or part of the process chamber, to a position that is more accessible. This makes the apparatus, more versatile in its placement on the manufacturing floor.

The process chambers are within the first zone. In this case the crane thus reduces the area needed around the process chambers, which would otherwise be needed for access by a service technician. With a reduced area needed around the process chambers, results in more equipment to be fitted into the manufacturing floor, thereby the manufacturing floor being more efficiently used.

Furthermore, the crane may increase the speed at which this maintenance and/or service can be performed.

In an aspect of the apparatus, the process chambers may be for processes such as deposition, etching, lithography, degassing, drying or cleaning.

In another aspect of the apparatus, the transfer chamber is equipped with a load lock, that ensures controlled transfer from the transfer chamber and into an EFEM or ambient atmosphere or a cassette, or from the an EFEM or ambient atmosphere or a cassette to the transfer chamber.

The crane arm may be configured for displacing at least part of the at least two process chambers between the first zone to the second zone and vice versa.

In an embodiment, one or more of the process chambers may comprise a pivotable lid being pivotable around an axis, wherein the pivotable lid pivot up to 120 degrees or up to 90 degrees.

Process chambers need to be maintained or serviced regularly and generally; this is performed by accessing parts of the process chambers through a lid. However, depending on how this lid opens may affect accessibility, and how accessible paths are designed around the apparatus or process chamber. The process chambers of this invention, have pivotable lids that can pivot up to 120 degrees or up to 90 degrees.

As the lids are pivotable up to 120 degrees or 90 degrees, this ensures that the lids do not expand excessively on the manufacturing floor. Having pivotable lids thereby creates more available space on the manufacturing floor, compared to solutions where the lids open 180 degrees.

The lids capacity to pivot up to 120 degrees or 90 degrees, may independently be more difficult to access compared to other solutions as the lid may at least partly block access to the internal parts of the process chamber making, thereby making it difficult for a person to lift said parts then the crane may compensate as the crane is stable and can thereby be used to lift said parts. Even if the lids are pivoted to 120 degrees or 90 degrees the crane can still hold or displace the process chamber or part of the process chamber to a more accessible configuration. Thus, an advantage of combining the crane and the pivotable lids, is that a better space utilization is obtained on the manufacturing floor.

In an embodiment, one or more of the process chambers are linear magnetron sputter chambers comprising a magnetron sputter module or magnetron sputter chambers comprising a magnetron sputter module.

In an embodiment, the apparatus may comprise a controller configured for controlling the crane.

When maintaining the apparatus or the process chambers, the crane needs to be displaced regularly. In cases where the displacement is facilitated by manual labour, there is a larger need for access around the apparatus, while also needing greater attention to safety. However, if the crane is controlled by a controller this would save even more space on the manufacturing floor, avoid risks of injury and also be faster.

In one aspect of the crane, the crane may be displaced manually, while in another aspect it could be moved by a hydraulic, pneumatic or electric motor controlled by a controller.

However, in some embodiments the crane arm i.e. arm segments are displaced by a person pushing or pulling the arm segments.

In an embodiment, the engagement means may be a hoisting system or a pulley or a spool or a winch for lifting at least a part of the apparatus. The engagement means may be a pulley with a wire or chain or band for engaging part of the apparatus, wherein a user can lift said part by pulling the wire or chain. The engagement means may be spool for engaging part of the apparatus using a wire or chain. The engagement means may be winch for engaging part of the apparatus, wherein the winch may be an electric winch for lifting said part of the apparatus using a wire or a chain or a band. In all cases, the wire or the chain or the band may include a hook or a shackle for attachment to the part of the apparatus or for gripping part of the wire or chain or band if the wire or the chain or the band is coiled one or more times around the part of the apparatus to be lifted.

When the crane holds parts of a process chamber for service or maintenance, it might be difficult to lift the parts up to the engagement means for the crane to hold. The parts may be lifted manually up for engagement means for the crane to hold, however, if the parts are heavy, manual lifting might cause safety issues. One way to avoid risks with manual lifting, is to have the crane comprise a hoisting system or pulley or spool or winch. The hoisting system or pulley or spool or winch may be actuated by manually by pulling a wire or a chain or a band manually or by use of an electric motor.

The hoisting system or pulley or spool or winch may ease the process of lifting parts of the process chamber, as it would require less force compared to manually lifting the parts of the process chamber. When lifting parts of the process chamber manually, it is reasonable to think that more access is needed in the area around the part of the process chamber. Furthermore, compared to lifting manually, the hoisting system might further speed up the lifting. Thus, by equipping the crane with a hoisting system may reduce the risk of injury, make it possible to better utilize manufacturing floor and also increase speed of maintenance and/or service.

In an aspect, the hoisting system may also make it easier to lift the whole process chamber, the apparatus, or parts of the apparatus.

The hoisting system could be a manual or electric hoist, pulley, or winch.

In an embodiment, the crane arm may comprise three, four, five or more arm segments or a plurality of arm segments.

The amount of arm segments on the crane generally influences the arm's length and flexibility. In one aspect, the crane arm may hold its length constant but comprise an increased number of smaller arm segments. This would increase its flexibility. In another aspect, the crane would hold the arm segments length constant, then the amount of arm segments would change the cranes length and thus reach. Thereby, a variable number of arm segments, increase the versatility of the crane and the crane can thus be designed and configured for different needs.

In an embodiment, the apparatus may comprise an Equipment Front End Module (EFEM) or a wafer cassette connected to the transfer chamber.

The EFEM is able to efficiently and reliably handle wafer automatically with a high precision.

During use of the EFEM, the EFEM will also need regular maintenance and service. The crane of the apparatus of the present invention may also be able to reach and support in the maintenance and service of the EFEM in the same manner as for the apparatus and process chambers. Thus, the crane increases efficiency and space utilization for many types of manufacturing tools arranged around the apparatus.

In an embodiment, two or more cranes may be arranged centrally on the transfer chamber or at a first end and/or a second end of the transfer chamber.

In some cases, one crane may not be enough to support the manufacturing process around the apparatus. Therefore, it might be necessary to arrange additional cranes on the apparatus. This way, multiple cranes could be used to support maintenance and service of a single process chamber and/or multiple process chambers at the same time. This would increase the general speed of maintenance and service, ensuring a higher uptime for manufacturing.

In an embodiment, the crane may comprise a base pillar, wherein the crane arm is connected to the base pillar. The base pillar may also be connected to the apparatus, preferably near the transfer chamber.

In an embodiment of the apparatus, the engagement means is a hook or a safety hook or a shackle.

By having the engagement means being a hook or a safety hook, or a shackle makes it easier for the crane to interact with the apparatus, which increases safety and speed of engagement with part of the apparatus.

In an embodiment of the apparatus, the apparatus further comprises one or more load locks.

In a further aspect of the apparatus, there may be a plurality of load locks arranged on the apparatus. This may increase the number of wafers that can be loaded or unloaded from the apparatus at one time. As loading and unloading the apparatus takes time due to the vacuum needed inside the apparatus. Having multiple load locks, may increase manufacturing speed, due to the capacity of being able to load or unload more samples at the same time.

In another embodiment of the apparatus, it might have a plurality of load locks, with some being specialized in loading and other being specialized in unloading. As the contamination might be different between wafers going in the apparatus compared to wafers unloaded from the apparatus. Specific designed load locks could increase the quality of the wafers.

In an embodiment, the base pillar is tiltable connected to the apparatus, thereby enabling a reduction in height during transportation of said apparatus.

One objective of the invention is achieved by a method for displacing part of an apparatus for use in semiconductor manufacturing. The apparatus defining a first zone and a second zone being outside the first zone. The method comprises steps of
- engaging a part of the apparatus with an arm segment of a crane arm, the crane arm comprising a series of arm segments;
- displacing the arm segments from the first zone to the second zone or from the second zone to the first zone.

The method of displacing part of an apparatus as described above is both safe and reliable. Wherein, safe and reliable are compared to displacing part of the apparatus manually by hand. When moving parts over large distances, it can be exhausting, especially if the parts are heavy, if the parts are move manually. This could lead to damaging the parts if dropped, leading to, in worst case, production stop. Another possible outcome could be injury. However, by displacing part of the apparatus using a crane this is avoided and it also enables better use of manufacturing space as the maintenance space requirement can be reduced.

Furthermore, displacing part of the apparatus manually by hand would also require more open space in the path from the apparatus to the destination, if compared to just moving normally. As space on the manufacturing floor needs to be utilized fully, this extra open space would be a waste. By using the crane, the extra open space would not be necessary, as the crane would do the displacement. This is a further argument, that the displacement with the crane severely increase space utilization.

In an embodiment, the step of displacing may involve a step of rotating an arm segment relative to a neighbouring arm segment around a rotary axis.

When the segment is able to rotate relative to a neighbouring, creates a highly flexible crane. With higher flexibility, the crane is able to move more freely within the cranes reach. Thereby being able to adapt to a higher variety of situations and needs.

### Description of the Drawing

Various examples are described hereinafter with reference to the figures. Like reference numerals refer to like elements throughout. Like elements will, thus, not be described in detail with respect to the description of each figure. It should also be noted that the figures are only intended to facilitate the description of the examples. They are not intended as an exhaustive description of the claimed invention or as a limitation on the scope of the claimed invention. In addition, an illustrated example doesn't need to have all the aspects or advantages shown. An aspect or an advantage described in conjunction with a particular example is not necessarily limited to that example and can be practiced in any other examples even if not so illustrated, or if not so explicitly described.

Exemplary embodiments of the invention are described in the figures, whereon:
- Fig. 1A: illustrates a side view of an embodiment of the apparatus with two 90-degree open pivotable lids and two 120-degree open pivotable lids.
- Fig. 1B: illustrates a top view of an embodiment of the apparatus with two 90-degree open pivotable lids and two 120-degree open pivotable lids.
- Fig. 1C: illustrates a top view of an embodiment of the apparatus, with two 90-degree open pivotable lids and two 120-degree open pivotable lids and the crane operation zone marked.
- Fig. 2A: illustrates a side view of an embodiment of the apparatus with all pivotable lids closed.
- Fig. 2B: illustrates a top view of an embodiment of the apparatus with all pivotable lids closed.
- Fig. 2C: illustrates a top view of an embodiment of the apparatus with all pivotable lids closed, and the crane operation zone marked.
- Fig. 3A: illustrates a side view of an embodiment of the apparatus, with all pivotable lids being open in 90-degrees.
- Fig. 3B: illustrates a top view of an embodiment of the apparatus, with all pivotable lids being open to 90-degrees.
- Fig. 3C: illustrates a top view of an embodiment of the apparatus, with all pivotable lids being open to 90-degrees and the crane operation zone marked.
- Fig. 4A: illustrates a side view of an embodiment of the apparatus, with all pivotable lids being open in 180-degrees.
- Fig. 4B: illustrates a top view of an embodiment of the apparatus, with all pivotable lids being open to 180-degrees.
- Fig. 4C: illustrates a top view of an embodiment of the apparatus, with all pivotable lids being open to 180-degrees and the crane operation zone marked.
- Fig. 5A: illustrates a view of an embodiment of the apparatus with an engagement means arranged on an arm segment.
- Fig. 5B: illustrates a view of an embodiment of the apparatus with an engagement means arranged on an arm segment.
- Fig. 5C: illustrates a view of an embodiment of the apparatus with an engagement means arranged on an arm segment.
- Fig. 6A: illustrates a perspective view of an embodiment of the apparatus wherein the crane is above a process chamber with an open pivotable lid.
- Fig. 6B: illustrates a top view of an embodiment of the apparatus wherein the crane is above a process chamber with an open pivotable lid, with the crane's operation zone marked.
- Fig. 6C: illustrates a top view of an embodiment of the apparatus wherein the crane is above a process chamber with an open pivotable lid.
- Fig. 7: illustrates a crane arm with a winch;
- Fig. 8: illustrates an embodiment of the apparatus being a linear cluster tool with a crane;
- Fig. 9: illustrates an embodiment of the apparatus being a linear cluster tool with two cranes;
- Fig. 10: illustrates a method of displacing part of an apparatus for use in semiconductor manufacturing.

### Detailed Description of the Invention

Exemplary examples will now be described more fully hereinafter with reference to the accompanying drawings. In this regard, the present examples may have different forms and should not be construed as being limited to the descriptions set forth herein. Accordingly, the examples are merely described below, by referring to the figures, to explain aspects.

Throughout the specification, when an element is referred to as being "connected" to another element, the element is "directly connected" to the other element, "electrically connected", "fluidically connected" or "communicatively connected" to the other element with one or more intervening elements interposed there between.

The terminology used herein is for the purpose of describing particular examples only and is not intended to be limiting. As used herein, the terms "comprises" "comprising" "includes" and/or "including" when used in this specification specify the presence of stated features, integers, steps, operations, elements, and/or components, but do not preclude the presence or addition of one or more other features, integers, steps, operations, elements, components, and/or groups thereof.

Unless otherwise defined, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined in the present specification.

| **Item** | **No.** |
|---|---|
| Apparatus | 100 |
| Transfer chamber | 110 |
| Chamber openings | 112 |
| Chamber sides | 114 |
| Process chamber | 120 |
| Pivotable lid | 122 |
| Crane | 130 |
| Crane arm | 131 |
| Arm segments | 132 |
| Flexible joints | 133 |
| Engagement means | 135 |
| Base pillar | 136 |
| Winch | 137 |
| Transfer line | 140 |
| First zone | 142 |
| Second zone | 144 |
| Equipment Front End Module (EFEM) or a wafer cassette | 160 |
| Crane operating zone | 200 |
| Method | 1000 |
| Engaging | 1100 |
| Displacing | 1200 |
| Rotating | 1300 |
| | |

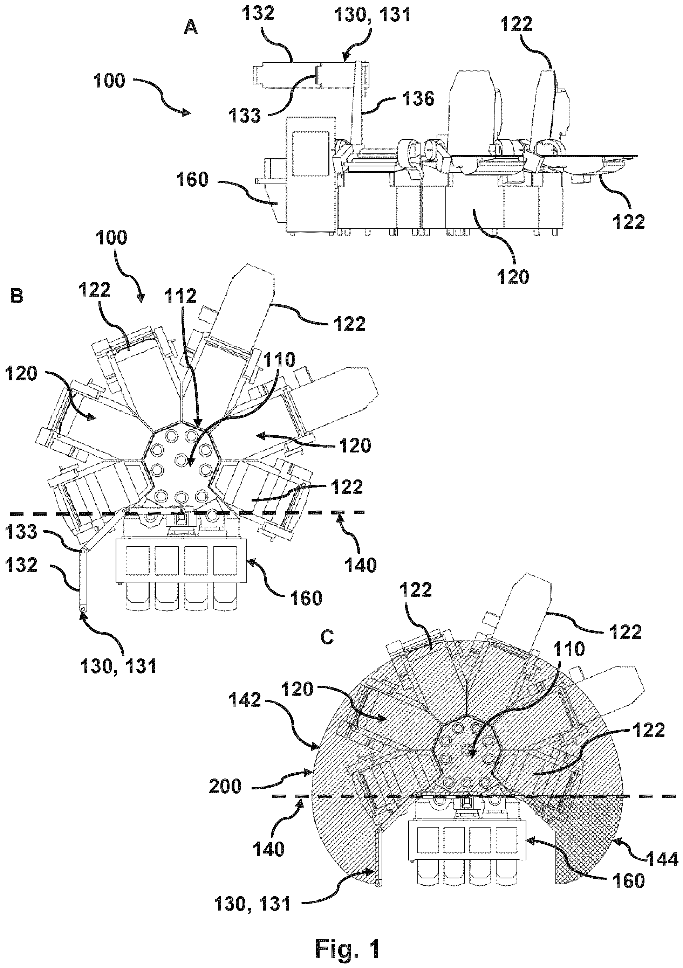

Fig. 1 illustrates three different views of an embodiment of the apparatus 100. Fig 1.A illustrates the embodiment of the apparatus 100 viewed from the side. Fig. 1.B illustrates the embodiment of the apparatus 100 viewed from the top. Fig. 1.C illustrates the embodiment of the apparatus 100 viewed from the top where the crane operating zone 200 is marked.

All the views illustrate the same embodiment of the apparatus 100, wherein the apparatus 100 comprises a transfer chamber 110 that is arranged with six process chambers 120. The transfer chamber 110 further comprises chamber openings 112 between the transfer chamber 110 and each attached process chamber 120. The chamber openings 112 ensures passage between the transfer chamber 110 and the process chamber 120. The transfer chamber 110 has an EFEM 160 arranged at one side of the transfer chamber 110. The EFEM 160 is connected to the transfer chamber 110 through a load lock. The transfer chamber 110 may comprise one or more load locks. Furthermore, a crane 130 is arranged on the transfer chamber 110, wherein the crane arm 131 comprises three arm segments 132 that are interconnected through flexible joints 133. The crane 130 may be arranged with engagement means and is able to work within the marked crane operating zone 200 in fig. 1C, where a first zone 142 is most above process chambers 120 and a second zone 144 is mostly outside the process chambers 120.

In fig. 1, two of the pivotable lids 122 are arranged at 90 degrees and two other pivotable lids 122 are arranged at 120 degrees. It is clear from fig. 1.B that when the pivotable lid 122 are arranged open at 90 degrees occupies less space than when open at 120 degrees.

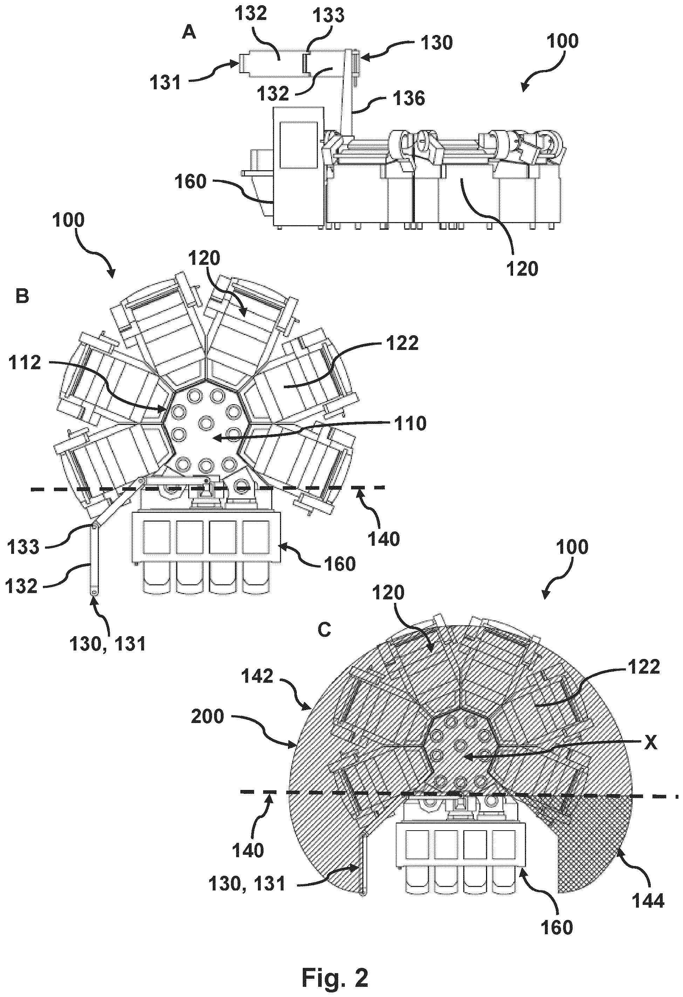

Fig. 2 illustrates three different views of an embodiment of the apparatus 100. Fig 2.A illustrates the embodiment of the apparatus 100 viewed from the side. Fig. 2.B illustrates the embodiment of the apparatus 100 viewed from the top. Fig. 2.C illustrates the embodiment of the apparatus 100 viewed from the top where the crane operating zone 200 is marked.

Fig. 2 resemble the illustration in fig. 1. However, it differs from fig. 1 by having all the pivotable lids 122 of the process chambers 120 closed. Thus, fig. 2 illustrates how little space the apparatus 100 can occupy, which may increase the effectivity per area of a factory.

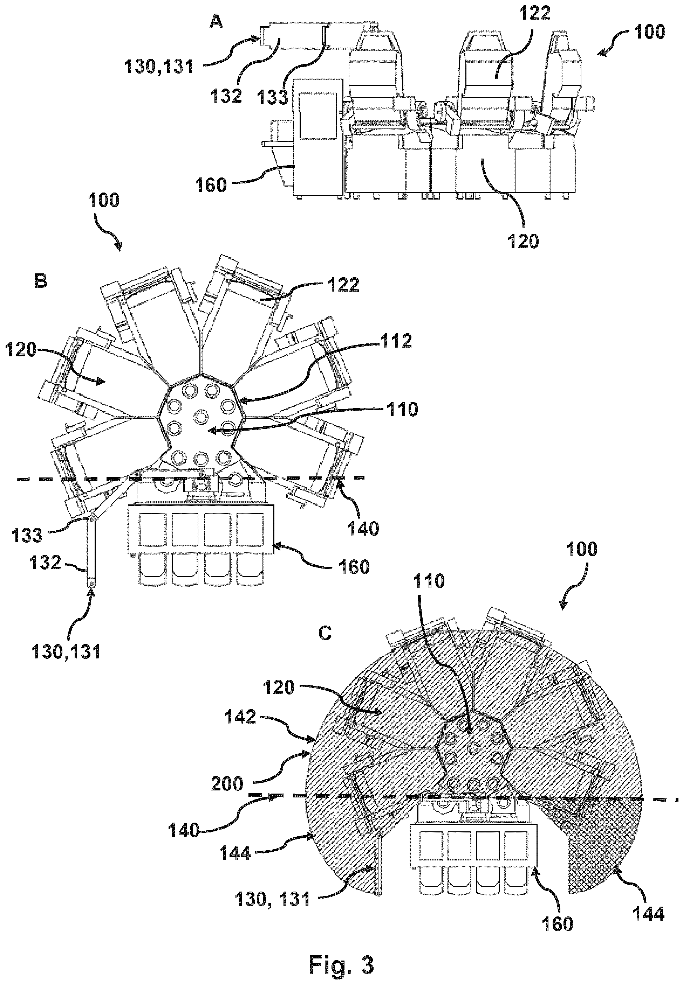

Fig. 3 illustrates three different views of an embodiment of the apparatus 100. Fig 3.A illustrates the embodiment of the apparatus 100 viewed from the side. Fig. 3.B illustrates the embodiment of the apparatus 100 viewed from the top. Fig. 3.C illustrates the embodiment of the apparatus 100 viewed from the top where the crane operating zone 200 is marked.

Fig. 3 resembles the illustration in fig. 1 and fig. 2. However, it differs from fig. 1 and fig. 2 by having all the pivotable lids 122 of the process chambers 120 open, arranged at 90 degrees. Thus, fig. 3 illustrates how little space the apparatus 100 can occupy, even in an open configuration.

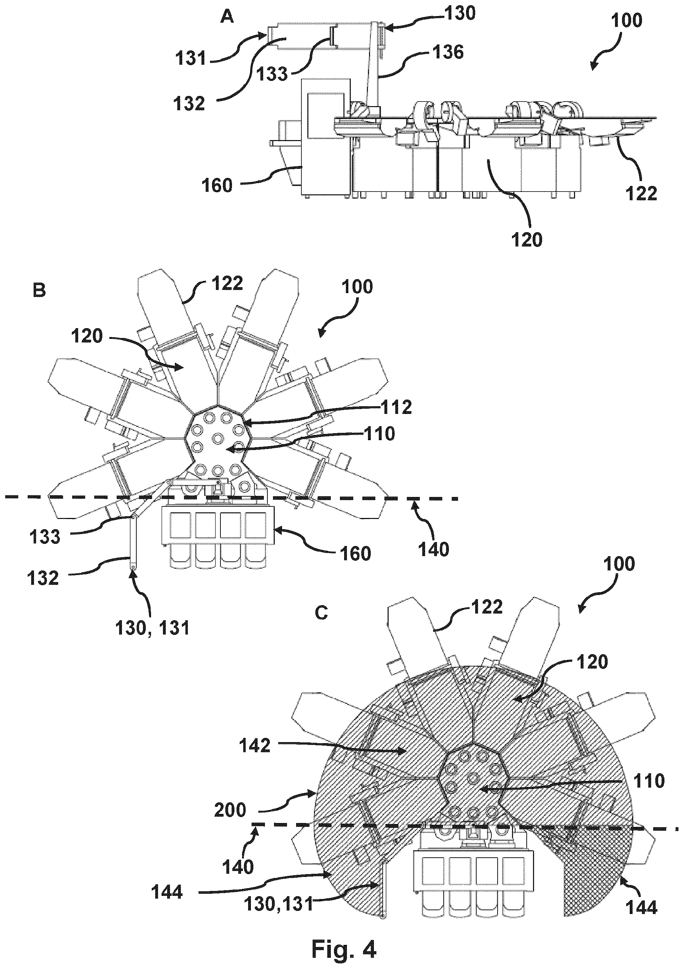

Fig. 4 illustrates three different views of an embodiment of the apparatus 100. Fig 4.A illustrates the embodiment of the apparatus 100 viewed from the side. Fig. 4.B illustrates the embodiment of the apparatus 100 viewed from the top. Fig. 4.C illustrates the embodiment of the apparatus 100 viewed from the top where the crane operating zone 200 is marked.

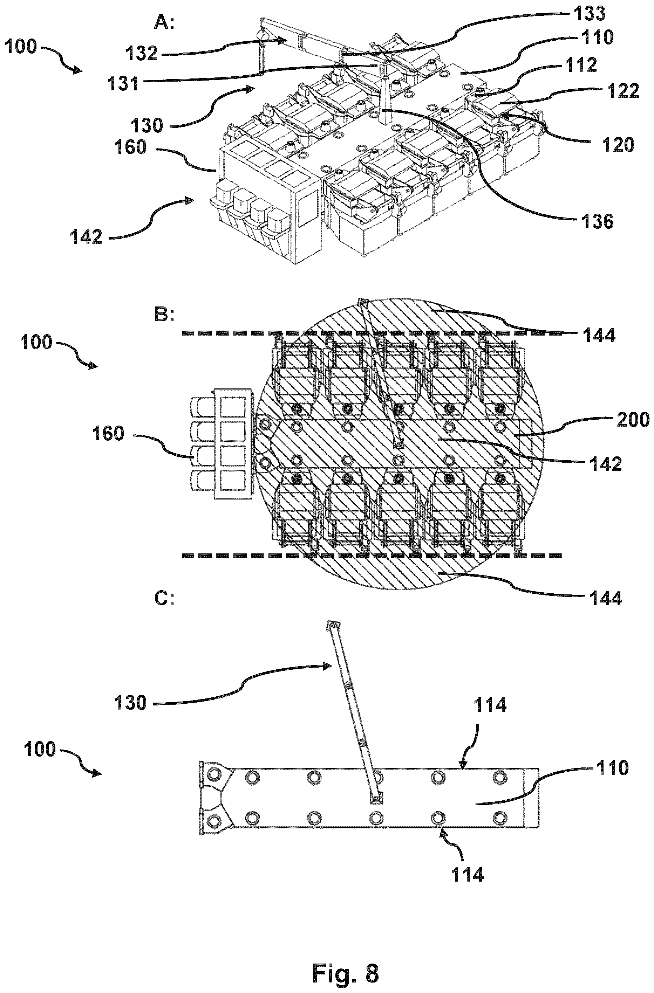

Fig. 4 resembles the illustration in fig. 1, fig. 2 and fig. 3. However, it differs from fig. 1, fig. 2 and fig. 3 by having all the pivotable lids 122 of the process chambers 120 open arranged at 180-degrees. The amount of space required by the apparatus is considerably greater than the apparatus of figure 3 since the radius is in effect increased by the length of the lid. It is well-known that the area of a circle increases with the squared radius thus any increase in radius results in a greater increase in required manufacturing area. Figure 8-9 discloses a linear cluster, which also requires more space if the pivotable lids 122 open 180 degrees although the required space manufacturing area linearly with the width of the apparatus.

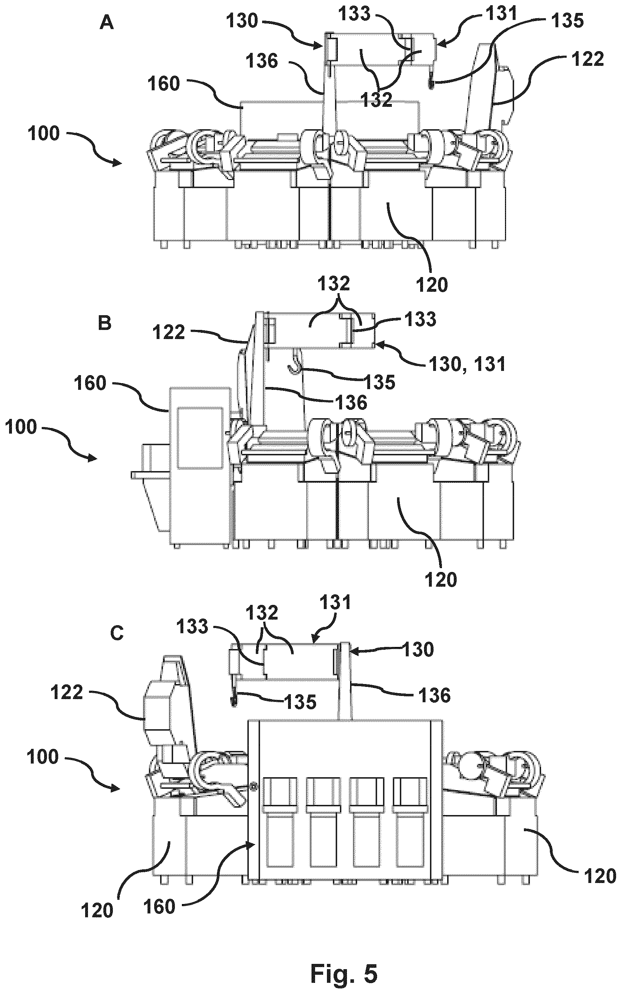

Fig. 5 illustrates three different side views of an embodiment of the apparatus 100 with an engagement means 135 arranged on an arm segment.

The embodiment of the apparatus 100 as illustrated in fig. 5 comprises process chambers 120 surrounding the transfer chamber 110, only interrupted by a EFEM 160 arranged at one side of the transfer chamber 110. One of the process chambers 120 have an open pivotable lid 122 arranged at 90-degrees, while the other process chambers 120 have closed pivotable lids 122. A base pillar 136 is arranged on the transfer chamber 110, wherein the crane arm 131 is connected to the base pillar 136. In this embodiment of the apparatus 100, the crane arm 131 comprises three arm segments 132 interconnected through flexible joints 133. The flexible joints 133 define a rotary axis and the arm segments 132 being rotatable around the rotary axes. The crane 130 further comprises engagement means 135 on the last arm segment 132, which in this illustration is a hook, but is not limited to a hook as it may be a shackle.

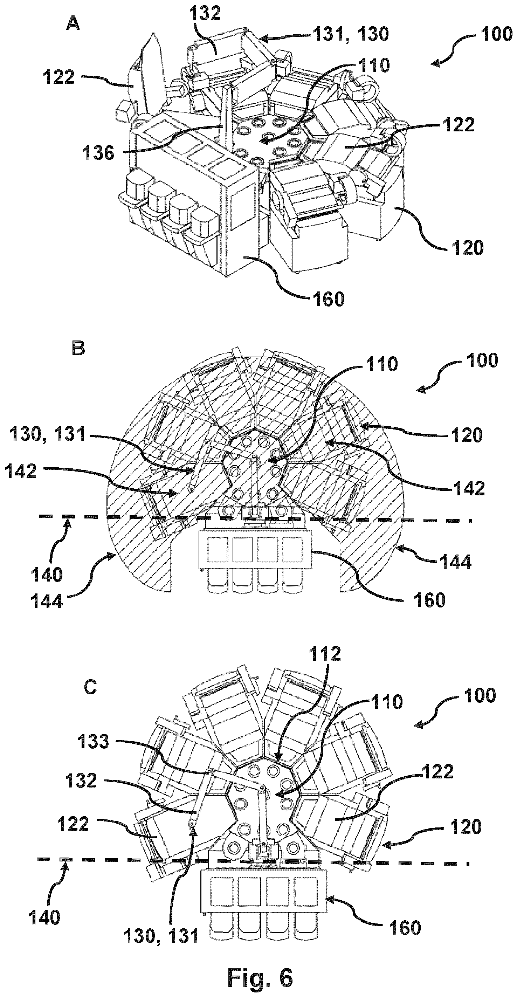

Fig. 6 illustrates perspective and top views of an embodiment of the apparatus 100 wherein the crane 130 is above a process chamber 120 with an open pivotable lid 122. The embodiment of the apparatus 100 is similar to the embodiment of the apparatus 100 illustrated in fig. 5.

In fig. 6.B the crane operating zone 200 is marked. This shows the area of the apparatus in which the crane 130 can operate. The crane operating zone 200 is divided into two sub zones. The first zone 142 is where the crane 130 operates substantially with or above the process chambers 120, while the second zone 144 is where the crane 130 is substantially an open area, next to the EFEM 160.

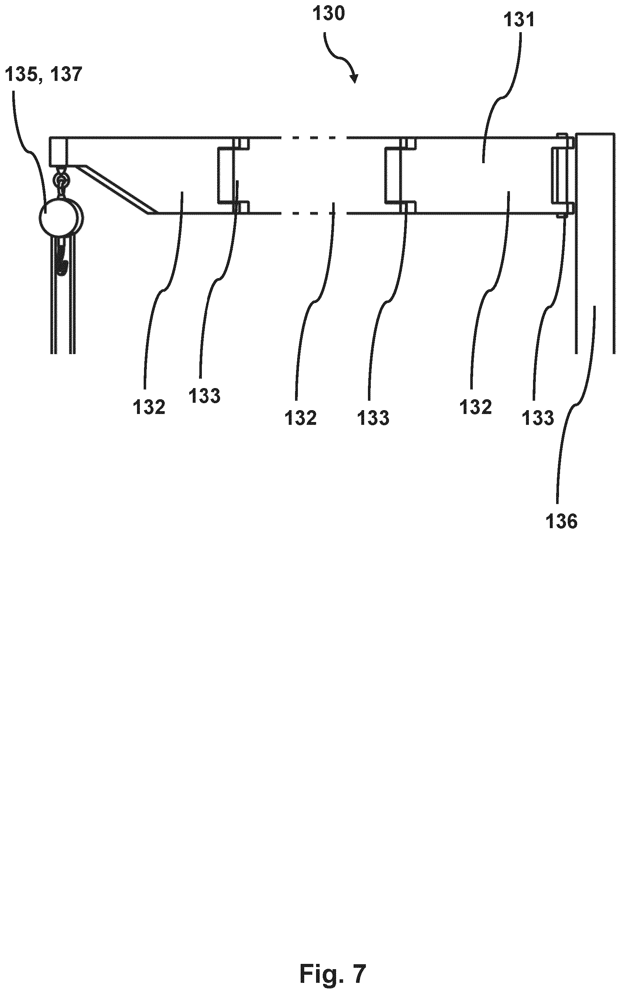

Fig. 7 illustrates a crane arm 131 with a winch 137. The figure discloses a crane 130 comprising a base pillar 136. The base pillar 136 will typically be connected to a transfer chamber 110 (not shown in figure 7) to ensure mechanical stability.

The crane arm 131 comprises in the shown embodiment three arm segments 132, however the number could be any number equal to or greater than two, preferably the number of arm segments 132 is three or greater as the flexibility of the crane arm 131 increases with the number of arm segments 132. There are a total of three flexible joints 133 which number increases and decreases with the number of arm segments 132. Each flexible joint 133 defines a rotary axis and the arm segments 132 being rotatable around the rotary axes. The rotary axes are all substantially parallel to gravitation vector thereby making the crane arm stable at any position.

The middle (or second) arm segment 132 is shown with dashed line to illustrate that the number could be any number equal to or greater than two. However, the number is preferably high such as higher than 5 as it also increases number of flexible joints 133 thereby enabling more manoeuvrability of the crane 130

The shown embodiment with any other number of arm segments 132 and flexible joints 133 can be combined with any of the discussed embodiments in the general description or any of the shown embodiments in the figures.

In the figure, the crane arm 131 is equipped with engagement means 135 in the form of a winch 137 with a hook. The hook could be replaced by a different unit for engaging a part of the apparatus such as a shackle. The winch 137 may be electrical winch such that a user is not needed to perform the lifting. The winch is electrical winch such that the number of generated particles is reduced compared to other winches which is important as the apparatus will be placed in a cleanroom.

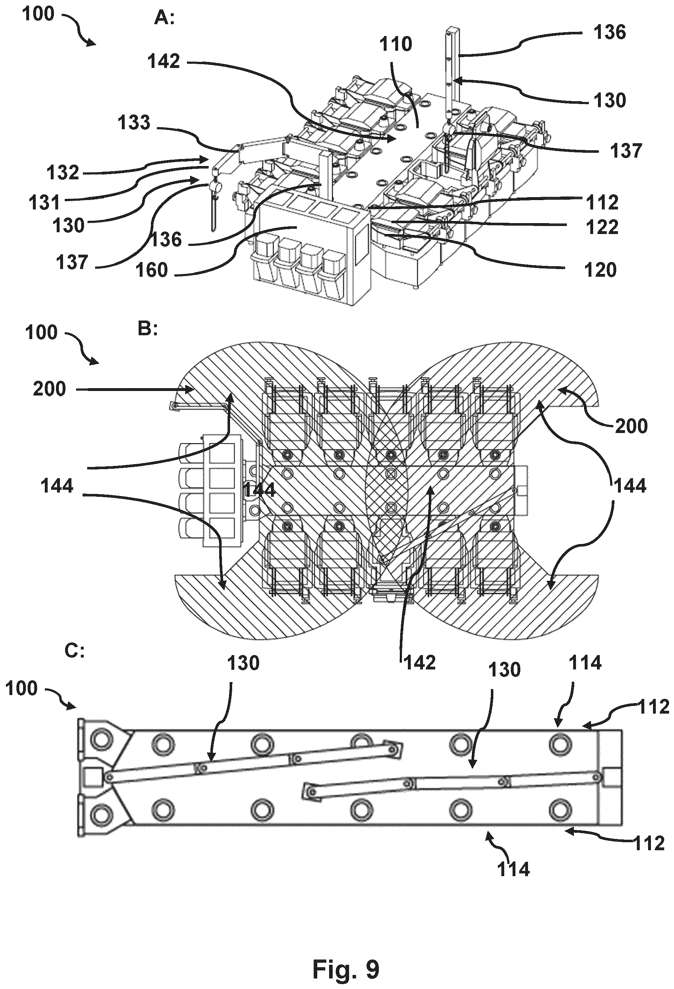

Fig. 8 illustrates an embodiment of the apparatus 100 being a linear cluster tool with a crane 130. Figure 9A discloses a perspective view, Figure 9B show a top view including zones 200, 142, 144, and Figure 9c show a top view of the apparatus without process chambers 120 and Equipment Front End Module (EFEM) 160.

The apparatus is designed for use in semiconductor manufacturing. The apparatus 100 defines a first zone 142 including transfer chamber 110 and the many process chambers 120. The first zone 142 will change depending on removal or replacement of the process chambers 120.

The apparatus also defines a second zone (144) being outside the first zone (142). The apparatus 100 has a crane 130 comprising a crane arm 131 with a series of arm segments 132 interconnected through flexible joints 133, where each flexible joint 133 defines a rotary axis and the arm segments 132 being rotatable around the rotary axes. The crane arm 131 further includes engagement means 135 in the form of a winch 137, preferably an electric winch. The winch 137 is arranged on at least one of the arm segments 132, where the engagement means 135 i.e. winch 137 are configured for engaging part of the apparatus 100.

At least one arm segment 132 is displaceable between part of the first zone 142 to part of the second zone 144. This arm segment includes the engagement means 135 i.e. winch 137 such that a part can be moved to and from the apparatus 100. The crane arm 131 will have a crane operating zone 200 defined by the series of arm segments 132 interconnected through flexible joints 133, which crane operating zone 200 is shown in figure 8B and includes part of the first zone 142 and part of the second zone 144.

The apparatus 100 is a linear cluster tool, wherein a transfer chamber 110 comprises two chamber sides 114 with the openings 112 for connection with process chambers 120. The transfer chamber 110 includes two load locks shown to the left side of figure 9C for connection with and EFEM 160 or similar equipment. During use, one or more process chambers 120 will be connected to the openings 112 and in the shown figure ten process chambers 120 are connected to the ten openings 112, however any number equal to or greater than two could be used.

In the shown embodiment, the crane 130 is positioned central on the transfer chamber 110 and the crane operating zone 200 includes all process chambers 120.

Fig. 9 illustrates an embodiment of the apparatus 100 being a linear cluster tool with two cranes 130. The apparatus 100 has all the same features of figure 8. The embodiment of figure 9 differs by having two cranes 130 positioned at opposite ends of a transfer chamber 110. Each crane 130 defines a crane operating zone 200, each crane operating zone 20 includes part of the first zone 142 and part of the second zone 144. The two crane operating zones 200 partially overlap, depending on the overlap this can enable transfer of a part from one crane 130 to the other crane 130.

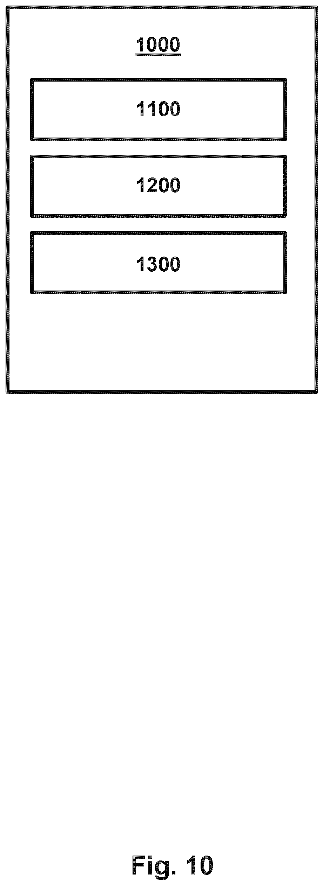

Fig. 10 illustrates a method 1000 of displacing part of an apparatus 100 for use in semiconductor manufacturing. The apparatus 100 defining a first zone (142) and a second zone 144 being outside the first zone 142; the method 1000 comprises steps of
- engaging 1100 a part of the apparatus with an arm segment 132 of a crane arm 131, the crane arm 131 comprising a series of arm segments 132; and
- displacing 1200 the arm segments 132 from the first zone 142 to the second zone 144 or from the second zone 144 to the first zone 142.

The step of displacing 1200 may involve a step of rotating 1300 an arm segment relative to a neighbouring arm segment 132 around a rotary axis.

## Claims

1. An apparatus (100) for use in semiconductor manufacturing, the apparatus (100) defines a first zone (142), and a second zone (144) being outside the first zone (142); and the apparatus (100) comprising:
- a crane (130) comprising
- a crane arm (131) comprising a series of arm segments (132) interconnected through flexible joints (133), where each flexible joint (133) defines a rotary axis and the arm segments (132) being rotatable around the rotary axes, and
- engagement means (135) arranged on at least one of the arm segments (132), where the engagement means (135) are configured for engaging part of the apparatus (100);
at least one arm segment (132) being displaceable between part of the first zone (142) to part of the second zone (144).

2. An apparatus (100) according to claim 1, wherein the apparatus (100) is a linear cluster tool, wherein a transfer chamber (110) comprises one chamber side with the openings or two chamber sides (114) with the openings (112) for connection with process chambers (120).

3. An apparatus (100) according to claim 1, wherein the apparatus (100) is a circular-like cluster tool comprising a transfer chamber (110) having two or more chamber sides (114) each with one or more openings (112) for connection with process chambers (120).

4. An apparatus (100) according to any of the preceding claims, wherein the apparatus (100) comprises at least two process chambers (120); and
the at least two process chambers (120) form part of the first zone (142); wherein the crane arm (131) is configured for reaching the at least two process chambers (120) within the first zone (142).

5. An apparatus (100) according to claim 4, wherein one or more of the process chambers (120) comprise a pivotable lid (122) being pivotable around an axis, wherein the pivotable lid (122) pivot up to 120 degrees or up to 90 degrees.

6. An apparatus (100) according to claim 4 or 5, wherein one or more of the process chambers (120) are linear magnetron sputter chambers or magnetron sputter chambers comprising a magnetron sputter module.

7. An apparatus (100) according to any of the preceding claims, wherein the apparatus (100) comprises a controller configured for controlling the crane (130).

8. An apparatus (100) according to any of the preceding claims, wherein the engagement means (135) being a hoisting system or a pulley or a spool or a winch for lifting at least a part of the apparatus (100).

9. An apparatus (100) according to any of the preceding claims, wherein the crane arm (131) comprises three, four, five or more arm segments (132) or a plurality of arm segments (132).

10. An apparatus (100) according to any of the preceding claims, wherein the apparatus (100) comprises an Equipment Front End Module (EFEM) (160) or a wafer cassette (160) connected to the transfer chamber (110).

11. An apparatus (100) according to any one of the preceding claims, wherein the apparatus comprises two or more cranes (130) arranged centrally on the transfer chamber (110) or at a first end and/or a second end of the transfer chamber (110).

12. An apparatus (100) according to any one of the preceding claims, wherein the crane (130) comprises a base pillar (136), where the crane arm (131) is connected to the base pillar (136).

13. An apparatus (100) according to claim 12, wherein the base pillar (136) is tiltably connected to the apparatus (100), thereby enabling a reduction in height during transportation.

14. A method (1000) for displacing part of an apparatus (100) for use in semiconductor manufacturing, the apparatus (100) defining a first zone (142) and a second zone (144) being outside the first zone (142); the method (1000) comprises steps of
- engaging (1100) a part of the apparatus with an arm segment (132) of a crane arm (131), the crane arm (131) comprising a series of arm segments (132);
- displacing (1200) the arm segments (132) from the first zone (142) to the second zone (144) or from the second zone (144) to the first zone (142).

15. A method (1000) according to claim 14, wherein the step of displacing (1200) involves a step of rotating (1300) an arm segment relative to a neighbouring arm segment (132) around a rotary axis.
